(19) Europäisches Patentamt
European Patent Office
Office européen des brevets

(11) **EP 3 155 713 B1**

(12) **EUROPÄISCHE PATENTSCHRIFT**

(45) Veröffentlichungstag und Bekanntmachung des Hinweises auf die Patenterteilung:
**24.03.2021   Patentblatt 2021/12**

(21) Anmeldenummer: **15717006.9**

(22) Anmeldetag: **20.04.2015**

(51) Int Cl.:
*H02M 1/36* *(2007.01)*    *H02M 3/156* *(2006.01)*
*H03K 4/502* *(2006.01)*    *H02M 1/00* *(2006.01)*

(86) Internationale Anmeldenummer:
**PCT/EP2015/058494**

(87) Internationale Veröffentlichungsnummer:
**WO 2015/188966 (17.12.2015 Gazette 2015/50)**

(54) **ANSTEUERSCHALTUNG, SPANNUNGSREGLER UND VERFAHREN ZUM BETREIBEN EINES SPANNUNGSREGLERS**

DRIVE CIRCUIT, VOLTAGE CONTROLLER AND METHOD FOR OPERATING A VOLTAGE CONTROLLER

CIRCUIT DE COMMANDE, RÉGULATEUR DE TENSION ET PROCÉDÉ POUR FAIRE FONCTIONNER UN RÉGULATEUR DE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.06.2014   DE 102014211110**

(43) Veröffentlichungstag der Anmeldung:
**19.04.2017   Patentblatt 2017/16**

(73) Patentinhaber: **Robert Bosch GmbH**
**70442 Stuttgart (DE)**

(72) Erfinder: **ROSAHL, Thoralf**
**72800 Eningen (DE)**

(56) Entgegenhaltungen:
**EP-A2- 0 205 140        US-A1- 2011 101 953**
**US-A1- 2011 316 511     US-A1- 2013 285 729**

EP 3 155 713 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Ansteuerschaltung, einen Spannungsregler sowie ein Verfahren zum Betreiben eines Spannungsreglers.

Stand der Technik

In nahezu allen elektronischen Systemen werden Spannungsregler eingesetzt, um aus einer sich verändernden Eingangsspannung eine konstante Systemversorgungsspannung zu erzeugen. Aufgrund ihrer hohen Effizienz kommen meist getaktete Spannungswandler zum Einsatz. Ist dabei die Eingangsspannung stets höher als die zu erzeugende Systemversorgungsspannung, fällt die Wahl häufig auf die Buck-Converter-Topologie, auch Abwärtswandler genannt.

Für die Regelung der Ausgangsspannung gibt es zahlreiche Verfahren. Zunächst wird zwischen den Verfahren mit konstanter Frequenz (Modulation der Pulsweite - PWM) und denen mit variabler Frequenz (Modulation der Frequenz bei konstanter ON- oder OFF-Time - PFM) unterschieden. In Systemen mit hohen Anforderungen an die elektromagnetische Abstrahlung (EME) wird bevorzugt die PWM-Regelung eingesetzt.

Bei den Systemen mit PWM-Regelung sind zwei Verfahren zur Erzeugung des PWM-Signals bekannt, dies sind die Voltage Mode Control (VMC) und die Current Mode Control (CMC).

Beide Verfahren haben individuelle Vor- und Nachteile und kommen deshalb nahezu zu gleichen Teilen zum Einsatz. Vorteil des Voltage Mode Control ist unter anderem, dass die Regelung nur aus einer Regelschleife besteht. Nachteilig ist zum Beispiel die Abhängigkeit der Schleifenverstärkung von der Eingangsspannung Vin. Bei Buck-Convertern mit einem großen Vin-Bereich müssen deshalb Maßnahmen getroffen werden, um diese Abhängigkeit zu kompensieren und im gesamten Vin-Bereich eine stabile Regelung zu gewährleisten.

US 2011/0316511A1 offenbart eine Ansteuerschaltung zur Erzeugung einer Sägezahnspannung für einen Spannungsregler die mindestens einen Widerstand und mindestens einen Kondensator zur Erzeugung der Sägezahnspannung basiert auf einer Eingangsspannung, umfasst.

Offenbarung der Erfindung

Erfindungsgemäß wird eine Ansteuerschaltung nach Anspruch 1 vorgesehen.

Die erfindungsgemäße Ansteuerschaltung hat den Vorteil, dass eine einfache, aber robuste Methode zur Steuerung eines konstanten Verhältnisses von Eingangsspannung Vin zu der Sägezahnspannung Vpp insbesondere für Buck-Converter mit Voltage Mode Control vorgestellt wird. Die Erfindung basiert auf dem Abgleich einer von der Ansteuerschaltung beziehungsweise einem Sägezahngenerator erzeugten Spannungsrampe auf einen vorgegebenen Spannungswert innerhalb einer Referenzzeit (Phase 1) vor dem Start des Spannungsreglers. Im anschließenden Betrieb des Spannungsreglers wird als Zielspannung der Ansteuerschaltung ein zu der Eingangsspannung proportionaler Wert, zum Beispiel über einen Spannungsteiler, verwendet. Damit ist in Phase 2 eine schnellstmögliche Anpassung der Sägezahnspannung bei Änderungen der Eingangsspannung gegeben. Dies ermöglicht insbesondere, dass eine schnellstmögliche Feedforward-Kompensation der Loop-Gain eines Spannungsreglers bei Veränderungen der Eingangsspannung erfolgt, dass ein Selbstabgleich des Feedforward-Pfades bei Systemstart oder auf Anforderung ermöglicht wird und/oder dass keine Veränderung der Loop-Gain über Varianzen in der Halbleiterprozess-Technologie oder über die Lebensdauer mehr vorliegt. Stattdessen ist die Varianz nur noch abhängig von der Zeitreferenz.

Der Zähler schaltet die Elemente derart, dass sich der Wert des Widerstands oder des Kondensators schrittweise verändert. Mit diesem systematischen Vorgehen ist eine sichere und schnelle Einstellung der Sägezahnspannung möglich.

In einer besonderen Ausführungsform ist vorgesehen, dass der Zähler ein Vier-Bit-Zähler ist. Dies erlaubt eine hohe Genauigkeit mit sechzehn Abstufungen, legt man eine Toleranz des Widerstandes von 20% und eine Toleranz des Kondensators von 10%, also eine Gesamttoleranz von 30%, zugrunde, kann mit einem Vier-Bit-Zähler eine Genauigkeit oder Auflösung von knapp 2% erreicht werden. Zwei oder Drei-Bit-Zähler können ebenso wie höherwertige Zähler eingesetzt werden. Es hat sich gezeigt, dass Drei- oder Vier-Bit-Zähler ein guter Kompromiss zwischen Aufwand und erreichbarer Genauigkeit sind.

Alternativ ist mit Vorteil vorgesehen, dass der Kondensator aus vier Elementen besteht, von denen drei durch einen Drei-Bit-Zähler schaltbar sind. Zu einem nicht schaltbaren Grundelement sind drei schaltbare Elemente vorgesehen, deren Werte, das heißt der Widerstand oder hier die Kapazität, sich vorzugsweise verdoppeln. Dies ist ein einfacher und wirkungsvoller Aufbau.

Gemäß einer bevorzugten Ausführungsform der Erfindung ist vorgesehen, dass ein analoger Multiplexer als vorgegebene Spannung eine Referenzspannung oder eine Eingangsspannung des Spannungsreglers zur Verfügung stellt. So kann unabhängig von dem Spannungsregler, also auch vor dessen Betrieb, mit der Referenzspannung die Ansteuerschaltung abgeglichen oder kalibriert werden. Zudem vereinfacht sich dieser Vorgang mit einer kontinuierlichen Referenzspannung.

Erfindungsgemäß wird ein Spannungsregler zum Einstellen der Höhe einer Ausgangsspannung zur Verfügung gestellt, wobei eine Ansteuerschaltung wie zuvor beschrieben den Spannungsregler ansteuert. Es gelten die gleichen Vorteile und Modifikationen wie zuvor beschrieben.

Gemäß einer bevorzugten Ausführungsform der Erfindung ist vorgesehen, dass der Spannungsregler ein Abwärtswandler ist. Diese Ausgestaltung, insbesondere in Form eines PWM-Spannungsreglers mit Voltage Mode Control, ist für die Erfindung besonders geeignet.

Das erfindungsgemäße Verfahren zum Betreiben eines Spannungsreglers mit einem gesteuerten Schalter zum Einstellen der Höhe einer Ausgangsspannung umfasst die Merkmale des Anspruchs 8.

In einer besonderen Ausführungsform ist vorgesehen, dass in einer ersten Phase vor einem Spannungswandlungsbetriebszustand des Spannungswandlers die vorgegebene Spannungsamplitude von einer Referenzspannung vorgegeben wird und wobei in einer zweiten Phase in dem Spannungswandlungsbetriebszustand des Spannungswandlers die vorgegebene Spannungsamplitude von einer Eingangsspannung des Spannungswandlers vorgegeben wird.

Die Kapazität des Kondensators kann durch einen Zähler schrittweise reduziert werden. Mit diesem systematischen Vorgehen ist eine sichere und schnelle Einstellung der Sägezahnspannung möglich.

Zeichnungen

Ausführungsbeispiele der Erfindung werden anhand der Zeichnungen und der nachfolgenden Beschreibung näher erläutert. Es zeigen:

Figur 1 ein schematisches Schaltbild eines Spannungsreglers;

Figur 2 ein schematisches Schaltbild einer Ansteuerschaltung für den Spannungsregler, und

Figur 3 ein Diagramm mit Spannungsverläufen einer Ansteuerschaltung.

Ausführungsformen der Erfindung

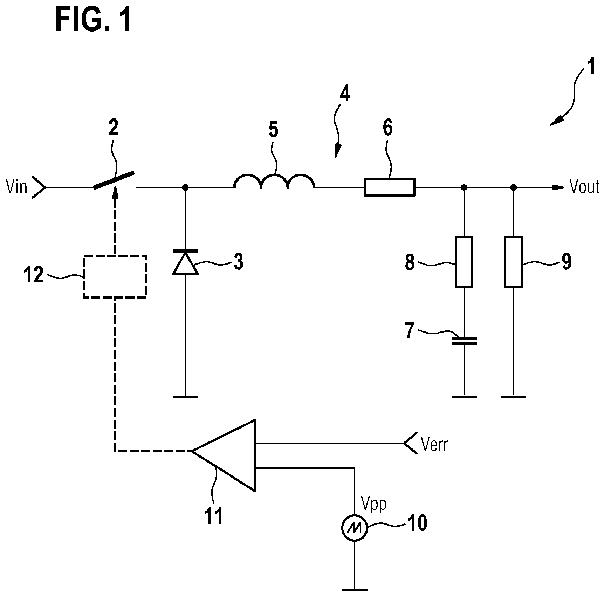

In Figur 1 ist schematisch ein Spannungsregler 1 dargestellt. Der Spannungsregler 1 ist ein Abwärtswandler oder Buck-Converter, der nach dem Prinzip der Modulation der Pulsweite (PWM) arbeitet. Der Spannungsregler 1 arbeitet gemäß dem Voltage-Mode-Control (VMC). Der Spannungsregler 1 erzeugt aus einer sich zeitlich verändernden Eingangsspannung Vin eine konstante Spannung Vout, welche beispielsweise als Systemversorgungsspannung für ein Bordnetz eines Kraftfahrzeugs beziehungsweise einzelner Komponenten wie zum Beispiel einem Steuergerät dient.

Der Spannungsregler 1 weist einen Schalter 2 beispielsweise in Form eines Schalttransistors auf. Hinter dem Schalter 2 ist eine Freilaufdiode 3 gegen Masse geschaltet. Um die Schaltverluste der Freilaufdiode 3 zu verringern, kann diese durch einen gesteuerten MOSFET ersetzt werden. Hinter der Freilaufdiode 3 ist in Längsrichtung eine Spule 4 angeordnet. Die Spule 4 hat eine Induktivität 5 und einen Wicklungswiderstand 6. Hinter der Spule 4 ist ein Stütz- oder Filterkondensator 7 mit möglichst geringem äquivalenten Serienwiderstand 8 gegen Masse geschaltet. Parallel zu dem Kondensator 7 ist ein Lastwiderstand 9 geschaltet, über dem die Ausgangsspannung Vout abfällt.

Weiterhin ist eine Ansteuerschaltung 10 zur Erzeugung einer Sägezahnspannung Vpp vorgesehen. Die Sägezahnspannung Vpp wird einem Komparator 11 zugeführt, an dessen zweiten Eingang ein Ausgangssignal oder Fehlersignal Verr eines die Pulsweitenmodulation regelnden Operationsverstärkers anliegt. Der Ausgang des Komparators 11 steuert gegebenenfalls über ein Verzögerungsglied 12 den Schalter 2 an. Dadurch wird der Tastgrad des Spannungsreglers 1 eingestellt, der definiert ist durch die Einschaltdauer des Schalters geteilt durch die Periodendauer.

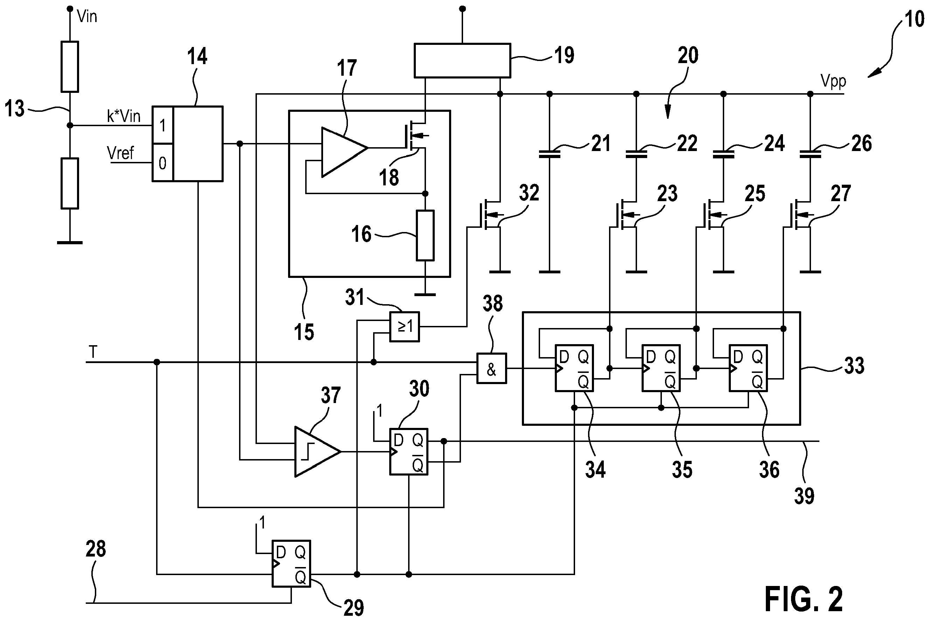

Anhand von Figur 2 wird nun die Ansteuerschaltung 10 näher beschrieben. Die Ansteuerschaltung 10 erzeugt aus einer Eingangsspannung Vin beziehungsweise Vref eine Sägezahnspannung Vpp mit konstanter Frequenz und variabler Amplitude, welche dem Wert k*Vin entspricht. Wobei der Wert k über einen Spannungsteiler 13 eingestellt wird.

Die Ansteuerschaltung 10 arbeitet in zwei Phasen, die sich im Wesentlichen dadurch unterscheiden, dass in einer ersten Phase von einem asynchronen Multiplexer 14 eine feste und definierte Referenzspannung Vref eingespeist wird. Die erste Phase liegt zeitlich vor dem eigentlichen Spannungswandlungsbetriebszustand des Spannungswandlers 1. In einer zweiten Phase, die dem Spannungswandlungsbetriebszustand des Spannungswandlers 1 entsprechen kann, wird von dem asynchronen Multiplexer 14 die Eingangsspannung des Spannungswandlers 1 beziehungsweise ein durch den Spannungsteiler 13 bestimmtes Verhältnis k*Vin der Eingangsspannung eingespeist.

Ein U/I-Wandler 15 wandelt die vorgegebene Spannung, welche wie beschrieben die Referenz- oder die Eingangsspannung sein kann, in einen Strom um. Der U/I-Wandler 15 umfasst einen Widerstand 16, einen Operationsverstärker 17 sowie einen Transistor 18. Der in dem U/I-Wandler erzeugte Strom wird einem Stromspiegel 19 zugeführt, der wiederum einen Ausgangsstrom in die Schaltung einspeist.

Dort ist ein Kondensator 20 gegen Masse geschaltet, der aus mehreren einzelnen Kondensatoren besteht. Ein Kondensator 21 ist direkt gegen Masse geschaltet und hat eine erste Kapazität Co. Ein weiterer Transistor 22 mit einer Kapazität Cn ist über einen Schalttransistor 23 gegen Masse geschaltet. Ein dritter Kondensator 24 mit der Kapazität 2*Cn ist über einen Schalttransistor 25 gegen Masse geschaltet. Ein vierter Kondensator 26 mit der Kapazität 4*Cn ist über einen Schaltkondensator 27 gegen Masse geschaltet.

Die Spannungsrampe du/dt der Sägezahnspannung Vpp wird durch den Widerstand 16 und den Kondensator 20 bestimmt. Entsprechend kann diese durch eine Anpassung des Widerstands 16 oder des Kondensators 20 geändert oder angepasst werden. Hier wird der Kondensator 20 geändert.

Im Folgenden wird nun der in Figur 2 unten dargestellte Steuerbereich der Ansteuerschaltung 10 beschrieben. Mit der Freigabe durch ein Disable-Signal 28, dass an einen Clear Eingang CLR eines Flip-Flops 29 geführt ist, startet die erste Phase oder der Abgleichzyklus. Ein Taktsignal T wird ebenfalls der Schaltung 10 zugeführt. Das Taktsignal T hat ein geringes Tastverhältnis oder anders ausgedrückt, sind die Signalanteile mit High-Pegel sehr gering gegenüber dem Takt. Zudem sollte die High-Phase des Taktsignals T so lang sein, dass die Entladung der Kondensatoren Co+n*Cn auf den Startwert der nächsten Periode stattfinden kann. Die High-Phase muss aber sehr viel kleiner als die Periode bleiben, da in dieser Zeit das Sägezahn-Signal noch nicht startet. Das Verhältnis von Co und Cn ist abhängig vom gewünschten Fangbereich, der vom Auto-Trimming abgedeckt werden soll.

Das Taktsignal wird dem Flop-Flop 29 zugeführt, sodass dieses mit der ersten steigenden Taktflanke gesetzt wird. Damit stellt das Flip-Flop 29 den Synchronbeginn der ersten Phase mit dem Taktsignal T sicher. Mit dem Setzen des Flip-Flops 29 wird ein weiteres Flip-Flop 30 aktiviert sowie ein ODER-Gatter 31 angesteuert, das daraufhin einen Schalttransistor 32 öffnet, über dem der Kondensator 20 entladen wird. Auch das Taktsignal T wird dem ODER-Gatter 31 zugeführt, sodass einmal pro Takt der Kondensator 20 entladen wird, um so die Sägezahnspannung Vpp zu erzeugen.

Ein Zähler 33 bestehend aus drei D-Flip-Flops 34, 35 und 36 steuert die drei Schalttransistoren 23, 25 und 27 an. Das Prinzip des Selbstabgleichs beruht darauf, dass die Kapazitäten 21, 22, 24 und 26 oder anders ausgedrückt die Gesamtkapazität 20 zur Erzeugung des Sägezahnsignals Vpp schrittweise so lange reduziert wird, bis innerhalb einer Periode des Taktes die Schwelle der Referenzspannung Vref erreicht wird.

Die Sägezahnspannung Vpp wird ebenso wie die Referenzspannung Vref einem Komparator 37 zugeführt, dessen Ausgang an einem Takteingang des Flip-Flops 30 anliegt. Der invertierende Ausgang Q' des Flip-Flops 30 ist mit einem Eingang eines UND-Gatters 38 verbunden. Der zweite Eingang des UND-Gatters 38 ist mit dem Taktsignal T beaufschlagt. Das UND-Gatter 38 ist mit dem Takteingang des ersten D-Flip-Flops 34 des Zählers 33 verbunden und dient somit der Ansteuerung des Zählers 33. Der Zähler 33 wird um eine Stufe heruntergezählt, wenn eine steigende Flanke des Taktsignals T anliegt und die Amplitude der Sägezahnspannung Vpp nicht die Amplitude der Spannung Vref erreicht hat. Dies wird über den Komparator 37 und das Flip-Flop 30 sichergestellt. Somit zählt der Zähler 33 immer weiter runter, was bewirkt, dass der Kapazitätswert des Kondensators 20 verringert wird, bis die Amplitude der Sägezahnspannung Vpp die Amplitude der Referenzspannung Vref erreicht.

Ist dies der Fall, wird das Flip-Flop 30 taktflankengesteuert und übernimmt den Wert 1 an seinen D-Eingang. Dies führt dazu, dass ein Trimmsignal 39, das den nun getrimmten Zustand der Ansteuerschaltung 10 anzeigt, ausgegeben wird. Ferner wird mit dem Trimmsignal 39 der asynchrone Multiplexer 14 umgeschaltet, sodass an dessen Ausgang nunmehr die Spannung k*Vin anliegt. Des Weiteren wird das UND-Gatter 38 gesperrt, sodass der Stand des Zählers 33 eingefroren ist, wodurch der Kapazitätswert des Kondensators 20 fest eingestellt bleibt.

Damit ist der weitere Zugang des Taktsignals T zum Zähler 33 unterbunden und der Zählerstand wird eingefroren. Das Signal 39 zeigt an, dass der Abgleich erfolgreich durchlaufen wurde und der Spannungsregler 1 nun für den Spannungswandlungsbetrieb freigegeben werden kann. In der nun anschließenden Phase 2 wird als Zielspannung für die Sägezahnspannung Vpp der Wert k*Vin vorgegeben.

Die Phase 1 endet, wenn Vpp = Vref/Ro * 1/(Co+n*Cn) * T ist, wobei Ro der Widerstandswert des Widerstands 16, Co der Wert der Kapazität des Kondensators 21, Cn der Wert der Kapazität des Kondensators 22 und T die Periodendauer des Taktsignals ist.

Während der Phase 2 gilt die folgende Beziehung:

$$Vin/Vpp = Ro * (Co+n*Cn)/T * 1/k$$

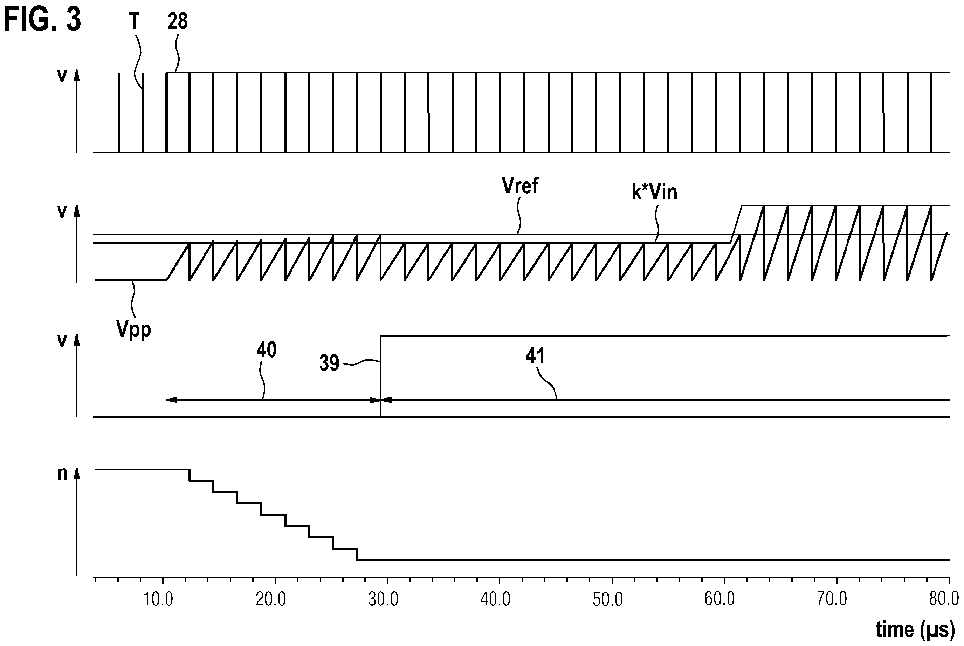

Im Folgenden werden anhand von Figur 3 die Signalverläufe einer Ansteuerschaltung 10 diskutiert. Die in Figur 3 dargestellten Signalverläufe entsprechen einer Schaltung mit einem Vier-Bit-Zähler. In Figur 2 ist eine Realisierung mit einem Drei-Bit-Zähler dargestellt. Mit dem Vier-Bit-Zähler ist ein weiterer Teilkondensator mit einer Kapazität von 8*Cn vorhanden, der durch ein viertes D-Flip-Flop des Zählers angesteuert wird. Die restlichen Bestandteile der Ansteuerschaltung 10 sind identisch.

In dem obersten Signalverlauf von Figur 3 ist zum einen das Taktsignal T dargestellt, das durch die kurze Einschaltdauer pro Periode charakterisiert ist. Zudem ist das Disable-Signal 28 dargestellt, welches im dritten Takt gesetzt wird.

Damit startet, wie in der zweiten Reihe von Figur 3 dargestellt ist, die Sägezahnspannung Vpp, deren Amplitude sich in den nächsten Takten kontinuierlich steigert, bis sie den Amplitudenwert der Referenzspannung Vref erreicht. Dies ist nach neun Zyklen der Fall, wie in dem untersten Diagramm von Figur 3 zu sehen ist. Dort ist der Zählerwert n des Zählers dargestellt. Der Zählerwert n ist zu diesem Zeitpunkt von ursprünglich 15 bis 7 herabgezählt worden.

Bei Erreichen der Amplitude der Referenzspannung Vref durch die Amplitude der Sägezahnspannung Vpp gibt der Komparator ein Ausgangssignal aus, was durch den senkrecht verlaufenden Signalverlauf in der dritten Zeile des Diagramms aus Figur 3 ersichtlich ist. In der dritten Zeile ist ebenfalls der Signalverlauf des Trimmsignals 39 dargestellt, das mit Ausgabe des Signals des Komparators 37 auf high gesetzt ist. Das Ausgangsignal des Komparators 37 unterteilt den Signalverlauf in eine erste Phase 40, in welcher die Referenzspannung Vref als Zielspannung für die Sägezahnspannung Vpp definiert ist, und eine zweite Phase 41, in der die Spannung k*Vin als Zielspannung für die Sägezahnspannung Vpp vorgegeben wird.

Dies zeigt sich in der zweiten Zeile von Figur 3, in der die Sägezahnspannung Vpp in der zweiten Phase 41 nunmehr dem etwas niedrigeren Spannungspegel der Spannung k*Vin folgt. Wie zu sehen ist, ändert sich zum Zeitpunkt von 60 μs die Amplitude der Spannung k*Vin, und die Sägezahnspannung Vpp folgt nahezu verzögerungsfrei dem neuen Zielwert.

## Patentansprüche

1. Ansteuerschaltung (10) zur Erzeugung einer Sägezahnspannung (Vpp) für einen Spannungsregler (1), aufweisend einen U/I-Wandler (15) mit einem Widerstand (16) und einen Kondensator (20) zur Erzeugung der Sägezahnspannung (Vpp) in einem Spannungswandlungsbetriebszustand basierend auf einer Eingangsspannung (Vin), wobei der U/I-Wandler (15) eingerichtet ist, eine vorgegebene Spannung in einen Strom umzuwandeln, wobei die Spannungsrampe du/dt der Sägezahnspannung (Vpp) durch den Widerstand (16) und den Kondensator (20) bestimmt wird,
J **dadurch gekennzeichnet**, das
die vorgegebene Spannung eine Referenz- (Vref) oder die Eingangsspannung (Vin) sein kann, der Widerstand (16) oder der Kondensator (20) mehrere einzeln schaltbare Elemente (21, 22, 24, 26) aufweist, die Ansteuerschaltung (10) einen Zähler (33) umfasst, der die einzeln schaltbaren Elemente (22, 24, 26) zur Erzeugung von Sägezahnspannungen unterschiedlicher Amplitude schrittweise ansteuert, und wobei die Ansteuerschaltung so eingerichtet ist, dass vor dem Spannungswandlungsbetriebszustand der Zähler (33) um eine Stufe heruntergezählt wird, wenn eine steigende Flanke eines Taktsignals (T) anliegt und die Amplitude der Sägezahnspannung (Vpp) nicht die Amplitude der Referenzspannung erreicht hat, und wobei die Ansteuerschaltung (10) einen Komparator (37) umfasst, der eingerichtet ist, den Zähler (33) anzuhalten, wenn die Sägezahnspannung (Vpp) innerhalb einer Periode eines Taktes die Referenzspannung (Vref) erreicht.

2. Ansteuerschaltung (10) nach Anspruch 1, wobei der Zähler (33) die Elemente (22, 24, 26) derart schaltet, dass sich der Wert des Widerstands (16) oder des Kondensators (20) schrittweise verändert.

3. Ansteuerschaltung (10) nach Anspruch 1 oder 2, wobei der Zähler ein Vier-Bit-Zähler ist.

4. Ansteuerschaltung (10) nach einem der Ansprüche 1 bis 3, wobei der Kondensator (20) aus vier Elementen besteht, von denen drei (22, 24, 26) durch einen Drei-Bit-Zähler (33) schaltbar sind.

5. Ansteuerschaltung nach einem der Ansprüche 1 bis 4, wobei die Ansteuerschaltung (10) ein analogen Multiplexer (14) umfasst, der als vorgegebene Spannung die Referenzspannung (Vref) oder eine Eingangsspannung (k*Vin) des Spannungsreglers (1) zur Verfügung stellt.

6. Spannungsregler (1) zum Einstellen der Höhe einer Ausgangsspannung (Vout), **dadurch gekennzeichnet, dass** die Spannungsregler (1) eine Ansteuerschaltung (10) nach einem der Ansprüche 1 bis 5 aufweist, die ausgelegt ist, den Spannungsregler (1) anzusteuern.

7. Spannungsregler (1) nach Anspruch 6, wobei der Spannungsregler (1) ein Abwärtswandler ist.

8. Verfahren zum Betreiben eines Spannungsreglers (1) mit einem gesteuerten Schalter (2) zum Einstellen der Höhe einer Ausgangsspannung (Vout), wobei eine Sägezahnspannung (Vpp) zur Ansteuerung des Spannungsreglers (1) erzeugt wird, wobei mittels eines sich in einem U/I-Wandler befindenden Widerstands (16) oder eines Kondensators (20), der mehrere einzeln schrittweise schaltbare Elemente (22, 24, 26) aufweist, die Amplitude der Sägezahnspannung (Vpp) mittels eines Zählers (33) verändert wird,
wobei der U/I-Wandler (15) eine vorgegebene Spannung, die eine Referenz- (Vref) oder die Eingangsspannung (Vin) sein kann, in einen Strom wandelt, wobei die Spannungsrampe du/dt der Sägezahnspannung (Vpp) durch den Widerstand (16) und den Kondensator (20) bestimmt wird, wobei vor einem Spannungswandlungsbetriebszustand der Zähler (33) um eine Stufe heruntergezählt wird, wenn eine steigende Flanke eines Taktsignals (T) anliegt und die Amplitude der Sägezahnspannung (Vpp) nicht die Amplitude einer Referenzspannung (Vref) erreicht hat, und wobei die Anzahl der schrittweise schaltbaren Elemente (22, 24, 26) beibehalten wird, wenn die Amplitude der Sägezahnspannung (Vpp) in einer Periode des Taktes der schaltbaren Elemente (22, 24, 26) die Referenzspannungsamplitude (Vref) erreicht.

9. Verfahren nach Anspruch 8, wobei in einer ersten Phase (40) vor dem Spannungswandlungsbetriebszustand des Spannungswandlers (1) die vorgegebene Spannungsamplitude von einer Referenzspannung (Vref) vorgegeben wird und wobei in einer zweiten Phase (41) in dem Spannungswandlungsbetriebszustand des Spannungswandlers (1) die vorgegebene Spannungsamplitude von einer Eingangsspannung (Vin) des Spannungswandlers (1) vorgegeben wird.

10. Verfahren nach Anspruch 8 oder 9, wobei die Kapazität des Kondensators (20) durch einen Zähler (33) schrittweise reduziert wird.

**Claims**

1. Drive circuit (10) for generating a sawtooth voltage (Vpp) for a voltage regulator (1), having a V/I converter (15) with a resistor (16) and a capacitor (20) for generating the sawtooth voltage (Vpp) in a voltage conversion operating state on the basis of an input voltage (Vin), wherein the V/I converter (15) is configured to convert a predefined voltage into a current, wherein the voltage ramp du/dt of the sawtooth voltage (Vpp) is determined by the resistor (16) and the capacitor (20), **characterized in that** the predefined voltage can be a reference voltage (Vref) or the input voltage (Vin), the resistor (16) or the capacitor (20) has multiple individually switchable elements (21, 22, 24, 26), the drive circuit (10) comprises a counter (33) that drives the individually switchable elements (22, 24, 26) in a stepwise manner to generate sawtooth voltages of different amplitudes, and wherein the drive circuit is configured such that, prior to the voltage conversion operating state, the counter (33) is decremented by one level upon a rising edge of a clock signal (T) and when the amplitude of the sawtooth voltage (Vpp) has not reached the amplitude of the reference voltage (Vref), and wherein the drive circuit (10) comprises a comparator (37) that is configured to stop the counter (33) when the sawtooth voltage (Vpp) reaches the reference voltage (Vref) within one period of a clock.

2. Drive circuit (10) according to Claim 1, wherein the counter (33) switches the elements (22, 24, 26) in such a way that the value of the resistor (16) or of the capacitor (20) changes in a stepwise manner.

3. Drive circuit (10) according to Claim 1 or 2, wherein the counter is a four-bit counter.

4. Drive circuit (10) according to one of Claims 1 to 3, wherein the capacitor (20) consists of four elements, three (22, 24, 26) of which can be switched by a three-bit counter (33).

5. Drive circuit according to one of Claims 1 to 4, wherein the drive circuit (10) comprises an analogue multiplexer (14) that provides the reference voltage (Vref) or an input voltage (k*Vin) of the voltage regulator (1) as the predefined voltage.

6. Voltage regulator (1) for setting the level of an output voltage (Vout), **characterized in that** the voltage regulator (1) has a drive circuit (10) according to one of Claims 1 to 5 that is designed to drive the voltage regulator (1).

7. Voltage regulator (1) according to Claim 6, wherein the voltage regulator (1) is a step-down converter.

8. Method for operating a voltage regulator (1) having a controlled switch (2) for setting the level of an output voltage (Vout), wherein a sawtooth voltage (Vpp) is generated to drive the voltage regulator (1), wherein the amplitude of the sawtooth voltage (Vpp) is changed by means of a counter (33) by means of a resistor (16), which is in a V/I converter, or a capacitor (20) which has multiple elements (22, 24, 26) that are individually switchable in a stepwise manner, wherein the V/I converter (15) converts a predefined voltage, which can be a reference voltage (Vref) or the input voltage (Vin), into a current, wherein the voltage ramp du/dt of the sawtooth voltage (Vpp) is determined by the resistor (16) and the capacitor (20), wherein, prior to a voltage conversion operating state, the counter (33) is decremented by one level upon a rising edge of a clock signal (T) and when the amplitude of the sawtooth voltage (Vpp) has not reached the amplitude of a reference voltage (Vref), and wherein the number of elements (22, 24, 26) that are switchable in a stepwise manner is maintained when the amplitude of the sawtooth voltage (Vpp) reaches the reference voltage amplitude (Vref) in a period of the clock of the switchable elements (22, 24, 26) .

9. Method according to Claim 8, wherein the predefined voltage amplitude is predefined by a reference voltage (Vref) in a first phase (40) prior to the voltage conversion operating state of the voltage converter (1) and wherein the predefined voltage amplitude is predefined by an input voltage (Vin) of the voltage converter (1) in a second phase (41) in the voltage conversion operating state of the voltage converter (1).

10. Method according to Claim 8 or 9, wherein the capacitance of the capacitor (20) is reduced in a stepwise manner by a counter (33).

**Revendications**

1. Circuit de commande (10) destiné à générer une tension en dents de scie (Vpp) destinée à un régulateur de tension (1), le circuit de commande comprenant un convertisseur U/I (15) muni d'une résistance (16) et d'un condensateur (20) pour générer la tension en dents de scie (Vpp) dans un mode de conversion de tension sur la base d'une tension d'entrée (Vin), le convertisseur U/I (15) étant conçu pour convertir une tension prédéterminée en un courant, la rampe de tension du/dt de la tension en dents de scie (Vpp) étant déterminée par la résistance (16) et le condensateur (20),
**caractérisé en ce que**
la tension prédéterminée peut être une tension de référence (Vref) ou la tension d'entrée (Vin), la résistance (16) ou le condensateur (20) comporte une pluralité d'éléments (21, 22, 24, 26) commutables individuellement, le circuit de commande (10) comprenant un compteur (33) qui commande pas à pas les éléments (22, 24, 26) commutables individuellement pour générer des tensions en dents de scie d'amplitudes différentes, et le circuit de commande étant conçu de sorte que le compteur (33) soit décompté d'un pas avant l'état de fonctionnement de conversion de tension lorsqu'un front montant d'un signal d'horloge (T) est présent et que l'amplitude de la tension en dents de scie (Vpp) n'a pas atteint l'amplitude de la tension de référence (Vref), et le circuit de commande (10) comprenant un comparateur (37) qui est conçu pour arrêter le compteur (33) lorsque la tension en dents de scie (Vpp) atteint la tension de référence (Vref) dans une période d'une horloge.

2. Circuit de commande (10) selon la revendication 1, le compteur (33) commutant les éléments (22, 24, 26) de telle sorte que la valeur de la résistance (16) ou du condensateur (20) change pas à pas.

3. Circuit de commande (10) selon la revendication 1 ou 2, le compteur étant un compteur à quatre bits.

4. Circuit de commande (10) selon l'une des revendications 1 à 3, le condensateur (20) comprenant quatre éléments dont trois (22, 24, 26) peuvent être commutés par un compteur à trois bits (33).

5. Circuit de commande selon l'une des revendications 1 à 4, le circuit de commande (10) comprenant un multiplexeur analogique (14) qui délivre la tension de référence (Vref) ou une tension d'entrée (k*Vin) du régulateur de tension (1) comme tension prédéterminée.

6. Régulateur de tension (1) destiné à régler le niveau d'une tension de sortie (Vout), **caractérisé en ce que** le régulateur de tension (1) comporte un circuit de commande (10) selon l'une des revendications 1 à 5 qui est conçu pour commander le régulateur de tension (1) .

7. Régulateur de tension (1) selon la revendication 6, le régulateur de tension (1) étant un convertisseur abaisseur.

8. Procédé de fonctionnement d'un régulateur de tension (1) pourvu d'un commutateur commandé (2) pour régler le niveau d'une tension de sortie (Vout), une tension en dents de scie (Vpp) étant générée pour commander le régulateur de tension (1), l'amplitude de la tension en dents de scie (Vpp) étant modifiée au moyen d'un compteur (33) à l'aide d'une résistance (16) située dans un convertisseur U/I ou d'un condensateur (20) qui comporte une pluralité d'éléments (22, 24, 26) qui peuvent être commutés pas à pas individuellement, le convertisseur U/I (15) convertissant une tension prédéterminée, qui peut être une tension de référence (Vref) ou la tension d'entrée (Vin), en un courant, la rampe de tension du/dt de la tension en dents de scie (Vpp) étant déterminée par la résistance (16) et le condensateur (20), le compteur (33) étant décompté d'un pas avant un état de fonctionnement de conversion de tension lorsqu'un front montant d'un signal d'horloge (T) est présent et que l'amplitude de la tension en dents de scie (Vpp) n'a pas atteint l'amplitude d'une tension de référence (Vref), et le nombre d'éléments (22, 24, 26) commutables pas à pas étant maintenu lorsque l'amplitude de la tension en dents de scie (Vpp) atteint l'amplitude de tension de référence (Vref) dans une période d'horloge des éléments commutables (22, 24, 26).

9. Procédé selon la revendication 8, l'amplitude de tension prédéterminée étant prédéterminée par une tension de référence (Vref) dans une première phase (40) avant l'état de fonctionnement de conversion de tension du convertisseur de tension (1) et l'amplitude de tension prédéterminée étant prédéterminée par une tension d'entrée (Vin) du convertisseur de tension (1) dans une deuxième phase (41) de l'état de fonctionnement de conversion de tension du convertisseur de tension (1).

10. Procédé selon la revendication 8 ou 9, la capacité du condensateur (20) étant réduite pas à pas par un compteur (33).

# FIG. 1

FIG. 2

# FIG. 3

T   28

V

Vref        k*Vin

V

Vpp

V

40    39    41

n

10.0    20.0    30.0    40.0    50.0    60.0    70.0    80.0

time (µs)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110316511 A1